(19) Europäisches Patentamt / European Patent Office / Office européen des brevets

(11) **EP 3 729 107 B1**

(12) **FASCICULE DE BREVET EUROPEEN**

(45) Date de publication et mention
de la délivrance du brevet:
**14.09.2022   Bulletin 2022/37**

(21) Numéro de dépôt: **18833976.6**

(22) Date de dépôt: **18.12.2018**

(51) Classification Internationale des Brevets (IPC):
**G01R 15/24** *(2006.01)*        **G01R 33/032** *(2006.01)*

(52) Classification Coopérative des Brevets (CPC):
**G01R 15/245; G01R 15/246; G01R 33/032**

(86) Numéro de dépôt international:
**PCT/FR2018/053380**

(87) Numéro de publication internationale:
**WO 2019/122693 (27.06.2019 Gazette 2019/26)**

(54) **DISPOSITIF DE MESURE D'UN CHAMP ÉLECTRIQUE ET/OU MAGNÉTIQUE NOTAMMENT DANS UN CONDUCTEUR DE TRANSPORT D'ÉNERGIE ÉLECTRIQUE**

VORRICHTUNG ZUR MESSUNG EINES ELEKTRISCHEN UND / ODER MAGNETISCHEN FELDES, INSBESONDERE BEI EINEM LEITER ZUM TRANSPORT VON ELEKTRISCHER ENERGIE

DEVICE FOR MEASURING AN ELECTRIC AND/OR MAGNETIC FIELD IN PARTICULAR IN A CONDUCTOR FOR TRANSPORTING ELECTRICAL POWER

(84) Etats contractants désignés:
**AL AT BE BG CH CY CZ DE DK EE ES FI FR GB GR HR HU IE IS IT LI LT LU LV MC MK MT NL NO PL PT RO RS SE SI SK SM TR**

(30) Priorité: **20.12.2017   FR 1762656**

(43) Date de publication de la demande:
**28.10.2020   Bulletin 2020/44**

(73) Titulaire: **Supergrid Institute**
**69100 Villeurbanne (FR)**

(72) Inventeurs:
• **RENON, Geoffrey**
  **69100 VILLEURBANNE (FR)**
• **VINSON, Paul**
  **69003 LYON (FR)**

(74) Mandataire: **Opilex**
**32, rue Victor Lagrange**
**69007 Lyon (FR)**

(56) Documents cités:
EP-A1- 2 626 711        US-A- 5 189 368
US-A1- 2012 113 423     US-A1- 2015 330 786

• **BRIAN CULSHAW ET AL: "Fiber-Optic Sensing: A Historical Perspective", JOURNAL OF LIGHTWAVE TECHNOLOGY, IEEE SERVICE CENTER, NEW YORK, NY, US, vol. 26, no. 9, 1 mai 2008 (2008-05-01), pages 1064-1078, XP011216263, ISSN: 0733-8724**

EP 3 729 107 B1

**Description**

Le domaine de la présente invention est relatif au transport d'électricité dans les réseaux de transport et distribution en haute tension en courant alternatif et en courant continu (High Voltage Alternative Current (HVAC) et High Voltage Direct Current (HVDC) en anglais) et plus particulièrement à un câble de transport d'énergie électrique d'un tel réseau ainsi qu'un dispositif associé permettant de mesurer un champ électrique et/ou magnétique, voir un courant et/ou une tension.

Le développement actuel des énergies renouvelables provoque de nouvelles contraintes au niveau du réseau électrique car les différents lieux de production d'électricité sont généralement éloignés les uns des autres et éloignés des zones de consommation. Il apparaît donc nécessaire de développer de nouveaux réseaux de transport capables de transporter de l'électricité sur de très longues distances tout en minimisant les pertes d'énergie.

Pour répondre à ces contraintes, les réseaux haute tension (par exemple 50kV) à courant continu (High Voltage Direct Current (HVDC) en anglais) apparaissent comme une solution prometteuse du fait de pertes en ligne inférieures aux réseaux à courant alternatif et d'absence d'incidence des capacités parasites du réseau sur de longues distances.

Pour contrôler le réseau de transport d'énergie électrique, on mesure à des endroits appropriés sur les lignes ou les postes électriques la tension et / ou le courant.

Pour ce faire, on connait par exemple les transformateurs inductifs composés d'un bobinage entourant le conducteur électrique / câble de transport d'énergie électrique et fonctionnant sur le principe de l'induction électromagnétique.

Toutefois, de tels dispositifs connus ne permettent pas des mesures sur des câbles de transport d'énergie électrique à courant continu.

Un autre défaut des dispositifs connus est lié au poids du bobinage entourant le conducteur électrique / câble de transport d'énergie électrique, notamment quand ce dernier est disposé en hauteur. En effet, dans ce cas, le poids du bobinage peut entraîner des contraintes mécaniques importantes sur les supports du dispositif de mesure.

Plus récemment, d'autres méthodes de mesure ont été mises au point pour s'affranchir des défauts précités.

EP 0453693 concerne un « capteur de champ électrique à effet Pockels ». Ce capteur présente un cristal destiné à être traversé par un faisceau lumineux monochromatique polarisé afin de déterminer la valeur d'un champ électrique et sa direction.

L'effet Pockels est l'apparition d'une biréfringence dans un milieu créée par un champ électrique statique ou variable. La biréfringence qui apparaît est proportionnelle au champ électrique qui peut donc être mesuré.

Le capteur de EP0453693 comprend en particulier une source lumineuse destinée à générer un faisceau lumineux monochromatique, un cristal sonde et un photodétecteur de type photodiode par exemple. La source lumineuse est reliée au cristal sonde par une fibre optique monomode et le cristal sonde est relié au détecteur par une fibre optique à maintien de polarisation.

Le cristal sonde utilisé présente une structure cristallographique particulière biréfringente lorsque soumis à un champ électrique de manière à ce que par mesure de la différence de phases entre les deux composantes de la polarisation du faisceau ayant traversé le cristal sonde, on puisse mesurer le champ électrique.

Toutefois, le cristal sonde utilisé est sensible aux variations de température ce qui rend son utilisation dans un réseau de transport d'énergie soumis aux variations climatiques délicat. On doit alors utiliser de plus un capteur de température et une unité de compensation pour corriger l'effet des variations de température sur les mesures.

Un autre effet pouvant être mis à profit pour mesurer par exemple un courant est l'effet Faraday. L'effet Faraday résulte de l'interaction entre la lumière et un champ magnétique dans un matériau. En effet, la polarisation de la lumière effectue une rotation proportionnelle à la composante du champ magnétique sur la direction de propagation de la lumière. Cette composante du champ magnétique étant proportionnelle au courant dans le conducteur électrique / câble de transport d'énergie, on peut alors mesurer le courant en mesurant la rotation de la polarisation.

Un exemple d'un tel dispositif de mesure est décrit dans EP0108012.

Le dispositif décrit dans ce document présente une fibre optique enroulée autour du conducteur électrique et dans laquelle passe un faisceau lumineux monochromatique généré par une source lumineuse, comme par exemple une diode laser. D'autre part, le dispositif décrit ici présente un dispositif d'analyse de la polarisation lumineuse au niveau de la sortie de la fibre optique. Le dispositif d'analyse comprend un cube séparateur polariseur, deux photodiodes détectant chacune des intensités de faisceaux lumineux polarisés linéairement et orthogonalement, et une unité analogique calculant le rapport représentatif de l'intensité à mesurer dans le conducteur électrique / câble de transport de l'énergie électrique.

Dans ce cas aussi, on observe une dépendance de l'effet Faraday par rapport à la température, ce qui nécessite une correction postérieure du résultat de mesure.

CN206057424 exploite encore un autre effet : l'effet Hall. Ce document divulgue un dispositif de mesure de courant comprenant un détecteur à effet Hall et une unité de détection de la température afin d'apporter des corrections aux mesures prises en fonction de la température du détecteur à effet Hall. Le dispositif décrit ici comprend également un microprocesseur destiné à traiter et corriger les données de tension mesurées par le détecteur à effet Hall. Ce document précise que le courant traversant le conducteur électrique / câble de transport de l'énergie électrique génère un champ magnétique proportionnel permettant de détecteur l'intensité et la tension du courant circulant dans le conducteur électrique / câble de transport de l'énergie électrique.

US 2012/0113423 A1 est relatif à un appareil de spectroscopie haute précision, plus particulièrement un appareil de spectroscopie par polarisation. Il observe que la configuration de spectroscopie par polarisation peut être utilisée pour mesurer des champs magnétiques avec une précision importante en utilisant un phénomène connu comme NMOR (Nonlinear Magnéto Optical Rotation).

La présente invention a pour objet de proposer un dispositif de mesure d'un champ électrique ou magnétique qui puisse s'affranchir des variations de température et qui peut être assez robuste pour pouvoir être installé dans des endroits soumis à des variations climatiques importantes.

A cet effet, la présente invention concerne un dispositif de mesure d'un champ magnétique et/ou d'un champ électrique comprenant :

- une cellule de mesure renfermant un gaz sensible à l'effet Zeeman et/ou à l'effet Stark, en particulier un gaz alcalin, et destinée à être disposée dans un champ magnétique et/ ou électrique,
- une source de lumière polarisée dont la longueur d'onde est accordée sur une raie d'absorption du gaz sensible à l'effet Zeeman et/ou à l'effet Stark et qui émet un faisceau de lumière traversant ladite cellule de mesure,
- au moins un système de polarimétrie configuré pour mesurer un premier paramètre correspondant à la rotation d'un angle de polarisation du fait de la traversée du faisceau dans la cellule de mesure renfermant un gaz sensible à l'effet Zeeman et/ou à l'effet Stark,
- un système de mesure d'absorption configuré pour mesurer un deuxième paramètre correspondant à l'absorption du faisceau par le gaz sensible à l'effet Zeeman et/ou l'effet Stark dans la cellule de mesure, et
- une unité de traitement configurée pour combiner la mesure du premier paramètre correspondant à la rotation de l'angle de polarisation et la mesure d'absorption pour en extraire un troisième et/ou quatrième paramètre correspondant respectivement à un champ électrique et/ou magnétique à mesurer.

L'invention peut en outre comprendre une ou plusieurs des aspects suivants pris seuls ou en combinaison :
Selon un aspect, le gaz alcalin est par exemple du rubidium, du lithium, du sodium, du potassium, du césium ou du francium.

Le dispositif peut comprendre une tête de mesure comprenant un séparateur de faisceau (une lame séparatrice ou un cube séparateur du faisceau) de lumière en provenance de la source de lumière polarisée en au moins deux faisceaux partiels de lumière et des réflecteurs pour définir deux branches de mesure perpendiculaires l'une à l'autre, la cellule de mesure étant disposée dans la tête de mesure au croisement des deux faisceaux partiels.

La tête de mesure est par exemple reliée à la source de lumière polarisée, le système de polarimétrie et le système de mesure d'absorption par des fibres optiques.

Selon un autre aspect, le parcours du faisceau de lumière traversant la cellule de mesure présente au moins une composante colinéaire au champ magnétique ou électrique à mesurer ou est colinéaire au champ magnétique ou électrique à mesurer.

La cellule de mesure peut être un cube ayant un premier côté de longueur comprise entre 0,1 mm et 20 mm et un deuxième côté de longueur comprise entre 0,1 mm et 25 mm ou un cylindre de hauteur comprise entre 0,1 mm et 20 mm et de diamètre compris entre 0,1 mm et 25 mm.

Le système de polarimétrie est notamment un système de polarimétrie balancée disposé en aval de la cellule de mesure et comprenant un séparateur polariseur de faisceau ainsi que deux photodétecteurs associés.

Le système de mesure d'absorption comprend par exemple une première et une deuxième lames séparatrices de faisceau disposées respectivement en amont et en aval de la cellule de mesure ainsi que deux photodétecteurs associés à chacune des lames séparatrices de faisceau et configurés pour détecter l'intensité lumineuse du faisceau de lumière en amont et en aval de la cellule de mesure.

La source de lumière est en particulier un laser, notamment une diode laser.

On peut prévoir une unique source de lumière laser utilisée à la fois pour mesurer au moins un champ électrique et au moins un champ magnétique.

L'invention concerne de plus une unité de mesure d'un courant et/ou d'une tension au niveau d'un conducteur électrique de moyenne ou haute tension comprenant au moins un dispositif de mesure tel que défini ci-dessus et en ce que l'unité de traitement est en outre configurée pour déterminer en fonction de la distance entre le conducteur électrique et la cellule de mesure une tension par rapport à la terre et/ou un courant électrique circulant dans le conducteur.

L'invention concerne en outre un poste sous enveloppe métallique comprenant une enveloppe métallique enfermant un conducteur électrique moyenne ou haute tension, dans lequel il comprend un dispositif de mesure tel que défini ci-dessus dont la cellule de mesure est disposée à l'intérieur du poste, notamment fixé contre la partie interne de l'enveloppe métallique.

D'autres caractéristiques et avantages de l'invention ressortiront de la description suivante, donnée à titre d'exemple et sans caractère limitatif, en regard des dessins annexés sur lesquels :

- la figure 1 représente un schéma illustratif concernant la polarisation de la lumière,
- la figure 2 présente deux schémas simplifiés modélisant des niveaux d'énergie d'un atome alcalin, ceci pour la partie a) en absence de tout champ électromagnétique et pour la partie b) en présence d'un champ magnétique ou électrique parallèle à la direction de propagation d'un faisceau de lumière,
- la figure 3 montre un schéma simplifié d'un dispositif de mesure selon un premier mode de réalisation,
- la figure 4 A est un schéma explicatif des champs électrique et magnétique formés autour d'un conducteur de courant,
- la figure 4B est un schéma simplifié montrant deux dispositifs de mesure agencés autour d'un conducteur de courant électrique pour mesurer à la fois le champ magnétique et le champ électrique à une distance prédéterminée du conducteur,
- la figure 5 est une variante simplifiée et optimisée du mode de réalisation de la figure 4B,
- la figure 6 est un exemple de réalisation d'un dispositif de mesure pour mesurer des champs électrique et/ou magnétique à proximité de plusieurs conducteurs électriques,
- la figure 7 est un schéma simplifié d'un deuxième mode de réalisation avec une tête de mesure d'une part et une embase de mesure d'autre part reliées l'une à l'autre par des fibres optiques,
- la figure 8 est un schéma simplifié d'un poste à enveloppe métallique comprenant un dispositif de mesure selon un troisième mode de réalisation, et
- les figures 9 et 10 sont des schémas simplifiés en coupe transversale d'un exemple de réalisation d'une tête de mesure de la figure 8.

Sur toutes les figures, les éléments ayant des fonctions identiques portent les mêmes numéros de référence.

Les réalisations suivantes sont des exemples. Bien que la description se réfère à un ou plusieurs modes de réalisation, ceci ne signifie pas nécessairement que chaque référence concerne le même mode de réalisation, ou que les caractéristiques s'appliquent seulement à un seul mode de réalisation. De simples caractéristiques de différents modes de réalisation peuvent également être combinées ou interchangées pour fournir d'autres réalisations.

Par « amont » ou « aval », on situe les éléments dans le sens de propagation de la lumière. Ainsi, un premier équipement ou élément est situé en amont d'un deuxième équipement ou élément si le faisceau de lumière traverse d'abord le premier puis le second équipement.

Dans le présent exposé, certaines références peuvent être complétées par une lettre désignant la finalité du champ devant être mesuré. Par exemple un photodétecteur 19 peut devenir un photodétecteur 19E quand il intervient dans la mesure d'un champ électrique et 19B dans le cas d'un champ magnétique. Une tête de mesure 33 peut devenir une tête de mesure 33E quand elle intervient dans la mesure d'un champ électrique et 33B dans le cas d'un champ magnétique ou 33EB si elle intervient à la fois pour une mesure d'un champ magnétique B et électrique E.

La présente invention concerne toute installation de moyenne ou haute tension, courant alternatif ou continu et notamment des conducteurs électriques / câbles de transport d'énergie électrique ou par exemple des postes avec isolation à air ou des postes sous enveloppe métallique.

La présente invention trouve une application particulièrement intéressante dans un réseau haute tension à courant continu (High voltage Direct Current (HVDC) en anglais) pour le transport d'énergie électrique, c'est-à-dire du courant.

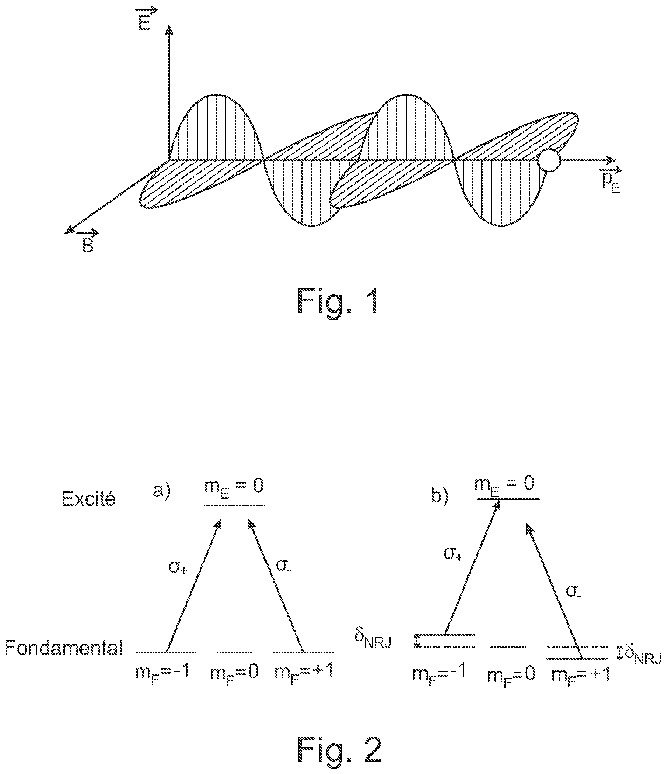

La figure 1 représente un schéma illustratif concernant la polarisation de la lumière. Une onde lumineuse est une onde électromagnétique dont le champ électrique $\vec{E}$ et le champ magnétique $\vec{B}$ forme un trièdre direct avec la direction de propagation $\vec{p_E}$ de cette onde. Ce champ électrique évolue au cours de la propagation de cette onde en décrivant une forme spécifique si on l'observe en faisant face à l'onde. Ainsi, la polarisation de l'onde (direction du champ électrique) au cours de sa propagation peut être classée en 3 catégories : polarisation rectiligne, polarisation circulaire et polarisation elliptique.

L'effet Zeeman (pour le champ magnétique B) et l'effet Stark (pour le champ électrique E) sont des effets qui ont lieu sur les niveaux énergétiques électroniques des atomes (alcalin entre autre). Ces effets peuvent être observés dès lors qu'on peut interagir avec ces niveaux énergétiques. Une façon d'interagir avec ces niveaux est d'utiliser l'interaction des spins électroniques des atomes en question avec des photons issus d'un rayonnement lumineux à résonance, par exemple un laser, avec le niveau d'énergie à interroger.

L'effet Zeeman ou l'effet Stark sera alors observable en utilisant une onde lumineuse à polarisation linéaire en interaction avec les niveaux d'énergie mis en jeu. Cette observation se fait en contrôlant la rotation de polarisation linéaire de l'onde lumineuse.

Ces effets peuvent particulièrement bien être observés par exemple dans des gaz formés d'atomes avec un seul électron de valence, comme par exemple des atomes alcalins. Les alcalins sont très utilisés dans de nombreuses applications du fait de l'unique électron de valence possédant un spin dépareillé qui peut être facilement manipulé. Ainsi, on peut faire l'approximation de l'énergie de l'atome par l'énergie du seul électron sur la bande de valence.

Toutefois, lorsqu'il s'agit d'un milieu gazeux, ces deux effets Stark et Zeeman dépendent de la densité du milieu traversé par la lumière et donc aussi de la température.

La figure 2 pour la partie a) présente un schéma simplifié modélisant des niveaux d'énergie d'un atome alcalin en absence de tout champ électromagnétique.

Il s'agit donc d'un système énergétique simplifié à trois niveaux (le sous-niveau fondamental $m_F = 0$ n'intervient pas dans le processus d'interaction atome-laser que l'on va décrire).

Ce système possède un niveau fondamental qui est composé de trois sous-niveaux fondamentaux de moment $m_F = -1$, $m_F = 0$, et $m_F = +1$. Ce système possède également un niveau excité sans sous-niveaux de moment $m_E = 0$.

Lorsqu'une onde lumineuse polarisée linéairement avec une direction de propagation donnée se propage, on peut décomposer cette polarisation linéaire en la somme de deux polarisations circulaires de sens opposé $\sigma_+$ et $\sigma_-$.

Ainsi l'onde lumineuse va interagir avec les deux sous-niveaux fondamentaux de moment $m_F = -1$ et $m_F = +1$ pour mettre l'électron sur le niveau excité de moment $m_E = 0$. Ceci s'explique par une règle de sélection concernant la conservation du moment cinétique et du fait que l'onde $\sigma_+$ échange un photon de moment +1 et l'onde $\sigma_-$ échange un photon de moment -1.

La figure 2 concernant la partie b) montre un schéma simplifié modélisant des niveaux d'énergie d'un atome alcalin en présence d'un champ magnétique $\vec{B}$ ou électrique $\vec{E}$ parallèle à la direction de propagation $\vec{p_E}$ d'un faisceau de lumière.

L'application d'un champ électrique $\vec{E}$ ou magnétique $\vec{B}$ colinéaire à la direction de propagation de l'onde lumineuse $\vec{p_E}$ entraine un déplacement énergétique des sous-niveaux fondamentaux de moment $m_F = -1$ et $m_F = +1$ (positif pour l'un et négatif pour l'autre, et inversement en cas de champ de sens opposé).

Dans le cas d'un champ électrique, cet effet est appelé effet Stark et la valeur de ce décalage en énergie $\delta_{NRJ}^{\vec{E}}$ vaut :

$$\delta_{NRJ}^{\vec{E}} = |\vec{\mu} \cdot \vec{p_E}| \left| \vec{E} \cdot \vec{p_E} \right|^2 \qquad \text{eq. (1)}$$

avec $\vec{\mu}$ le moment dipolaire de l'atome alcalin.

Dans le cas d'un champ magnétique $\vec{B}$ cet effet est appelé l'effet Zeeman et la valeur du décalage en énergie $\delta_{NRJ}^{\vec{B}}$ vaut alors :

$$\delta_{NRJ}^{\vec{B}} = \left| \vec{\mu_B} \cdot \vec{B} \right| \qquad \text{eq. (2)}$$

avec $\vec{\mu_B}$ le magnéton de Bore.

Il y a un écart d'énergie de $2\delta_{NRJ}^{\vec{E}}$ dans le cas d'application d'un champ électrique et $2\delta_{NRJ}^{\vec{B}}$ dans le cas d'application d'un champ magnétique entre les 2 sous-niveaux fondamentaux de moment $m_F = -1$ et $m_F = +1$ comme on peut le voir sur la figure 2b). Ceci génère donc une différence entre l'interaction de la composante $\sigma_+$ et la composante $\sigma_-$ avec les électrons de l'atome alcalin considéré.

Après reconstruction mathématique de la polarisation de l'onde lumineuse, la polarisation linéaire de l'onde lumineuse ayant traversée un milieu d'atome alcalin de longueur $\ell$ subie une rotation d'un angle $\theta$ de :

$$\theta_{\vec{E}} = \psi_{\vec{E}} \cdot n_{al} \cdot \ell \cdot E^2 \qquad \text{eq. (3)}$$

$$\theta_{\vec{B}} = \psi_{\vec{B}} \cdot n_{al} \cdot \ell \cdot B \qquad \text{eq. (4)}$$

avec

- $\psi_{\vec{E}}$ le paramètre d'interaction lumière matière en présence d'un champ électrique,
- E la composante du champ électrique selon l'axe de propagation de l'onde lumineuse $\vec{p_E}$,
- $\psi_{\vec{B}}$ le paramètre d'interaction lumière matière en présence d'un champ magnétique,
- B la composante du champ magnétique selon l'axe de propagation de l'onde lumineuse $\vec{p_E}$,
- $n_{al}$ la densité volumique d'alcalin qui est un paramètre dépendant de la température.

On comprend donc que la détection de la rotation de la polarisation de l'onde lumineuse par polarimétrie permet, lorsque l'on connaît la densité volumique ou que celle-ci est fixe, de mesurer un champ électrique et/ou un champ magnétique.

La densité de gaz alcalin présent dans une cellule de mesure est dépendante de la température (pression de vapeur saturante). Afin de d'affranchir de cette problématique, il est proposé d'utiliser le phénomène d'absorption du faisceau lumineux par le gaz alcalin. En effet, la puissance $P_T$ du faisceau de lumière en sortie d'une cellule de mesure en fonction de la puissance d'entrée $P_0$ est donnée par la relation :

$$P_T = P_0 e^{-\psi_{Abs} \cdot n_{al} \cdot \ell} \qquad \text{eq. (5)}$$

avec $\psi_{Abs}$ le paramètre connu d'interaction lumière matière due à l'absorption. On a alors :

$$\ln\left(\frac{P_0}{P_T}\right) = \psi_{Abs} \cdot n_{al} \cdot \ell \qquad \text{eq. (6)}$$

En isolant dans cette formule $n_{al}$ :

$$n_{al} = \ln\left(\frac{P_0}{P_T}\right) \frac{1}{\ell\,\psi_{Abs}} \qquad \text{eq. (7)}$$

Et en utilisant l'équation (7) dans les équations (3) et (4) ci-dessus, on peut donc s'affranchir de l'effet de la température.

$$\theta_{\vec{E}} = \ln\left(\frac{P_0}{P_T}\right) \frac{\psi_{\vec{E}}}{\psi_{Abs}} \cdot E^2 \qquad \text{eq. (8)}$$

$$\theta_{\vec{B}} = \ln\left(\frac{P_0}{P_T}\right) \frac{\psi_{\vec{B}}}{\psi_{Abs}} \cdot B \qquad \text{eq. (9)}$$

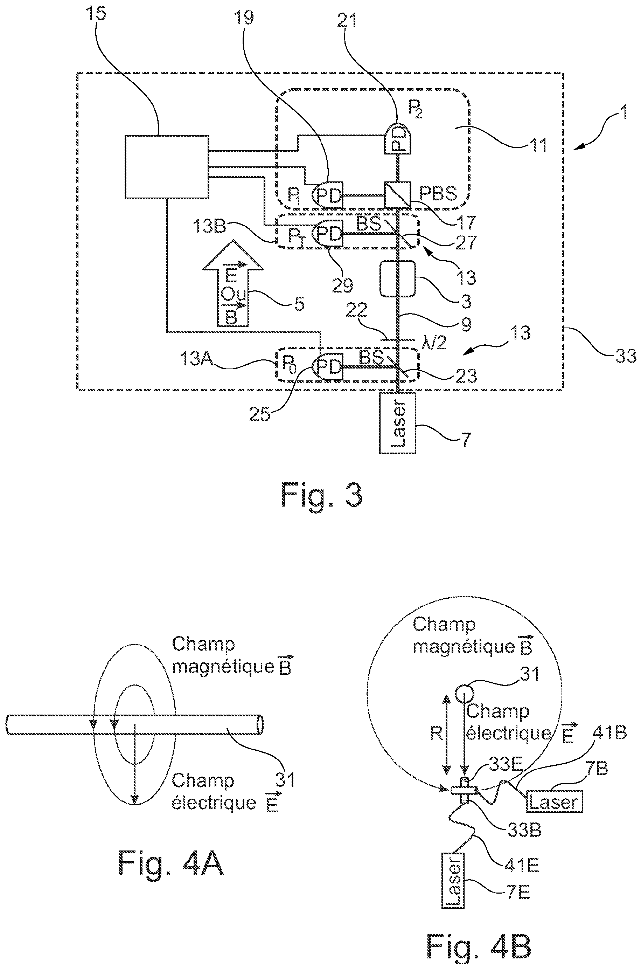

La figure 3 montre un exemple d'un schéma simplifié d'un dispositif de mesure 1 selon un premier mode de réalisation combinant à la fois la polarimétrie et la mesure d'absorption pour aboutir soit à une mesure du champ magnétique, soit à une mesure du champ électrique selon le cas si la propagation du faisceau de lumière est colinéaire au champ magnétique ou électrique.
Le dispositif de mesure 1 d'un champ magnétique et/ou d'un champ électrique comprend

- une cellule de mesure 3 renfermant un gaz sensible à l'effet Zeeman et/ou à l'effet Stark, en particulier un gaz alcalin, et destinée à être disposée dans un champ magnétique et/ ou électrique indiqué par la flèche 5,
- une source de lumière 7 polarisée dont la longueur d'onde est accordée sur une raie d'absorption du gaz sensible à l'effet Zeeman et/ou à l'effet Stark contenu dans la cellule de mesure 3 et qui émet un faisceau de lumière 9 traversant ladite cellule de mesure 3,
- un système de polarimétrie 11 configuré pour mesurer un premier paramètre correspondant à la rotation d'un angle de polarisation du fait de la traversée dans le gaz sensible à l'effet Zeeman et/ou à l'effet Stark du faisceau dans la cellule de mesure 3,
- un système de mesure d'absorption 13 configuré pour mesurer un deuxième paramètre correspondant à l'absorption par le gaz sensible à l'effet Zeeman et/ou à l'effet Stark du faisceau 9 dans la cellule de mesure 3, et
- une unité de traitement 15 configurée pour combiner la mesure du premier paramètre correspondant à la rotation de l'angle de polarisation et la mesure d'absorption pour en extraire un troisième et/ou quatrième correspondant respectivement à un champ électrique E et/ou magnétique B à mesurer.

Le gaz sensible à l'effet Zeeman et/ou à l'effet Stark contenu dans la cellule de mesure 3 est donc en particulier un gaz alcalin par exemple composé d'atomes de rubidium, de lithium, de sodium, de potassium, de césium ou de francium.

La cellule de mesure 3 est en particulier transparente à la longueur d'onde de la source de lumière 7 utilisée. Il suffit que seules les faces de passage du faisceau de lumière 9 soient transparentes. Les autres surfaces peuvent être opaques ce qui peut être avantageux pour éliminer des éventuel perturbations par la lumière ambiante.

La cellule de mesure 3 est par exemple un cube / parallélépipède ayant un premier côté de longueur comprise entre 0,1 mm et 20 mm et un deuxième côté de longueur comprise entre 0,1 mm et 25 mm ou un cylindre de hauteur comprise entre 0,1 mm et 20 mm et de diamètre compris entre 0,1 mm et 25 mm. Elle présente donc des dimensions assez petites pour pouvoir être installée en tout endroit approprié dans une installation de transport d'énergie électrique, voire, comme on va le détailler plus loin, pour l'intégrer dans l'équipement de cette installation. De plus, une petite cellule permet de jouer sur la plage de mesure tout en impactant la sensibilité.

La source de lumière 7 est par exemple un laser, notamment une diode laser. La longueur d'onde du laser est choisie en fonction de la transition d'absorption de l'alcalin choisi.

Le tableau suivant donne des exemples de longueurs d'onde pour un alcalin donné et une transition donnée.

| Alcalin | Longueur d'onde $\lambda_{D1}$ (nm) | Longueur d'onde $\lambda_{D2}$ (nm) |
|---|---|---|
| $^{39}$K = Potassium 39 | | |
| $^{40}$K = Potassium 40 | 770,108 | 766,701 |
| $^{41}$K = Potassium 41 | | |
| $^{85}$Rb = Rubidium 85 | 794,979 | 780,241 |
| $^{87}$Rb = Rubidium 87 | | |
| Cs = Césium | 894,593 | 852,347 |

Le système de polarimétrie 11 peut être en particulier un système de polarimétrie balancé (voir particulièrement figure 3,5 et 6) qui est disposé en aval de la cellule de mesure 3. Un tel système de polarimétrie 11 comprend notamment un séparateur polariseur de faisceau 17 ainsi que deux photodétecteurs associés 19 et 21.

Le séparateur polariseur de faisceau 17 (« polarizing beam splitter » en anglais - PBS sur les figures) sépare les composantes s et p de polarisation pour les envoyer respectivement sur les photodétecteurs 19 et 21 (« photodetector » en anglais - PD sur les figures), par exemple des photodiodes. Par exemple la composante de polarisation s est réfléchie à 90° en direction du photodétecteur 19 tandis que la composante p traverse le séparateur polariseur de faisceau 17 pour être détectée par le photodétecteur 21.

Ainsi, en tenant compte des signaux de mesure des photodétecteurs 19 et 21, on peut mesurer l'angle de polarisation du faisceau de lumière en sortie de la cellule de mesure 3 et on peut déterminer, en connaissant la polarisation linéaire de départ en sortie de la source de lumière 7, la variation de l'angle de polarisation qui permet de déterminer la valeur du champ électrique et/ou magnétique à mesurer.

Pour des raisons de simplification d'explication et non restrictive, on se place dans la situation où la polarisation d'entrée dans la cellule de mesure est à 45° par rapport à la composante s ou p du séparateur polariseur de faisceau 17.

On a alors le signal de sortie pour le champ électrique $\vec{E}$ et pour le champ magnétique $\vec{B}$, respectivement de composante E pour le champ électrique et de composante B pour le champ magnétique le long de l'axe de propagation du laser qui est donné par :

$$\theta_{\vec{E}} = \alpha_{Att} \cdot \frac{P_1 - P_2}{P_0} = \psi_{\vec{E}} \cdot n_{al} \cdot \ell \cdot E^2 \qquad \text{eq.(10)}$$

$$\theta_B = \alpha_{Att} \cdot \frac{P_1 - P_2}{P_0} = \psi_{\vec{B}} \cdot n_{al} \cdot \ell \cdot B \qquad \text{eq.(11)}$$

Avec

7

- E = composante du champ électrique E colinéaire avec la direction de propagation du faisceau de lumière 9,
- B = composante du champ magnétique B colinéaire avec la direction de propagation du faisceau de lumière 9,
- $\alpha_{Att}$ le coefficient d'atténuation connue ou prédéterminé du faisceau de lumière
- $P_1$ l'intensité de lumière mesurée par le photodétecteur 19
- $P_2$ l'intensité de lumière mesurée par le photodétecteur 21
- $P_0$ l'intensité de lumière mesurée par le photodétecteur 25

Bien entendu, on suppose dans notre cas que $\vec{E} \perp \vec{B}$, c'est-à-dire que le faisceau de lumière est orienté de manière à être sensible seulement à un des deux champs électrique ou magnétique.

Pour pouvoir régler la polarisation linéaire du faisceau de lumière 9 par rapport au séparateur polariseur de faisceau 17, une lame demi-onde 22 (aussi noté λ/2 sur les figures) est disposée en amont de la cellule de mesure 3.

Le système de mesure d'absorption 13 va servir pour s'affranchir de la dépendance de la température. Il comprend une partie amont 13A et une partie aval 13B. Plus en détail, la partie amont 13A comprend une première lame séparatrice 23 de faisceau (« beamsplitter » en anglais - BS sur les figures) disposée en amont de la cellule de mesure 3 ainsi qu'un photodétecteur 25 associé configurés pour détecter l'intensité lumineuse du faisceau de lumière 9 en amont de la cellule de mesure 3. La partie aval 13B comprend une seconde lame séparatrice 27 de faisceau disposée en aval de la cellule de mesure 3, mais en amont du système de polarimétrie 11, ainsi qu'un photodétecteur 29 associé configurés pour détecter l'intensité lumineuse du faisceau de lumière 9 en aval de la cellule de mesure 3. Les lames séparatrices 23 et 27 peuvent être remplacées par des cubes séparateurs.

Ce signal dépendant de la température peut alors être corrigé avec le signal d'absorption comme défini précédemment. Le signal de sortie pour le champ électrique de l'équation (10) ou pour le champ magnétique de l'équation (11) devient alors :

$$S_{\vec{E}} = \frac{\theta_{\vec{E}}}{\ln\left(\frac{P_0}{P_T}\right)} = \frac{\psi_{\vec{E}}}{\psi_{Abs}} \cdot E^2 \qquad \text{eq. (12)}$$

$$S_{\vec{B}} = \frac{\theta_{\vec{B}}}{\ln\left(\frac{P_0}{P_T}\right)} = \frac{\psi_{\vec{B}}}{\psi_{Abs}} \cdot B \qquad \text{eq. (13)}$$

On obtient ainsi un signal indépendant de la température permettant la mesure du champ électrique ou du champ magnétique. Pour remonter à la valeur absolue du champ E ou B à mesurer, on peut par exemple recourir à un calibrage pour déterminer la correspondance entre le signal de mesure S et la valeur du champ E ou B.

Pour remonter ensuite au courant électrique circulant dans un conducteur électrique ou la tension par rapport à la terre, il est nécessaire de prendre en compte la distance de la cellule de mesure 3 par rapport au conducteur électrique.

Etant donné que les atomes alcalins sont confinés dans la cellule de mesure, le taux d'absorption n'est finalement dépendant que de la température. Ainsi, l'utilisation du signal de $P_T$ sur le photodétecteur 29 permet également une mesure locale de la température. En effet, la densité d'alcalin $n_{al}$ est dépendante de la température $T$ en Kelvin avec par la relation suivante :

$$n_{al}(T) = \ln\left(\frac{P_0}{P_T}\right) \frac{1}{\ell\,\psi_{Abs}} = \frac{10^{18,9848+a-\frac{b}{T}}}{T} \qquad \text{eq. (14)}$$

avec *a* et *b* des paramètres propres à chaque alcalin.

Avec un calcul mathématique prenant en compte le signal $\frac{P_T}{P_0}$ , on peut donc mesurer la température locale simultanément à la mesure du champ électrique ou magnétique.

Sur la figure 3, la source de lumière 7 alimente directement le montage optoélectronique que l'on peut également appeler une tête de mesure 33.

Selon une variante, la source de lumière 7, c'est-à-dire par exemple un laser, est par exemple déportée de la tête de mesure 33, les deux étant reliées l'une à l'autre par une fibre optique.

La figure 4 A est un schéma explicatif des champs électrique $\vec{E}$ et magnétique $\vec{B}$ formés autour d'un conducteur de courant 31.

Le champ magnétique $\vec{B}$ est circulaire autour du conducteur 31, tandis que le champ électrique $\vec{E}$ pointe dans une direction radiale perpendiculaire au champ magnétique $\vec{B}$ .

La figure 4B est un schéma simplifié montrant le même conducteur électrique 31 en coupe transversale ainsi que les champs électrique $\vec{E}$ et magnétiques $\vec{B}$ formés autour d'un conducteur de courant électrique 31. De plus, on a indiqué de façon schématique deux têtes de mesure 33E, 33B électrique (E) et magnétique (B) de deux dispositifs de mesure 1 agencés autour du conducteur de courant électrique 31 pour mesurer à la fois le champ magnétique et le champ électrique à une distance R prédéterminée du conducteur électrique 31. Dans cet exemple de réalisation, les sources de lumière 7E et 7B sont reliées aux têtes de mesure 33E, 33B respectives par des fibres optiques 41, c'est-à-dire 41E entre la source de lumière 7E et la tête de mesure 33E et 41B entre la source de lumière 7B et la tête de mesure 33B.

Comme on le constate par l'orientation longitudinale des têtes de mesures 33E et 33B schématisées sur la figure 4B, le faisceau de lumière de la tête de mesure 33E est dans sa partie traversant la cellule de mesure 3 colinéaire avec la champ électrique $\vec{E}$ et le faisceau de lumière de la tête de mesure 33B est dans sa partie traversant la cellule de mesure 3 colinéaire avec la champ magnétique $\vec{B}$.

Dans cette configuration, le courant électrique I circulant dans le conducteur électrique 31 est donné par la relation :

$$I = \frac{2\pi R B}{\mu_0} \qquad \text{eq. (15)}$$

Où $\mu_0$ est la perméabilité magnétique du vide.

De façon analogue, on obtient la tension du conducteur électrique 31 par rapport à la terre.

La relation entre le champ électrique mesuré $E_0$ et la tension appliquée sur le conducteur de courant 31 $V_0$ est donnée par la relation suivante :

$$V_0 = r \ln\left(\frac{r_0}{r}\right) E_0 \qquad \text{(eq. 16)}$$

Bien entendu, en effectuant un calibrage avec un conducteur électrique 31 dans lequel circule un courant connu, on peut calibrer le dispositif de mesure 1 et corréler les signaux de mesure et le paramètre à mesurer (champ électrique ou magnétique).

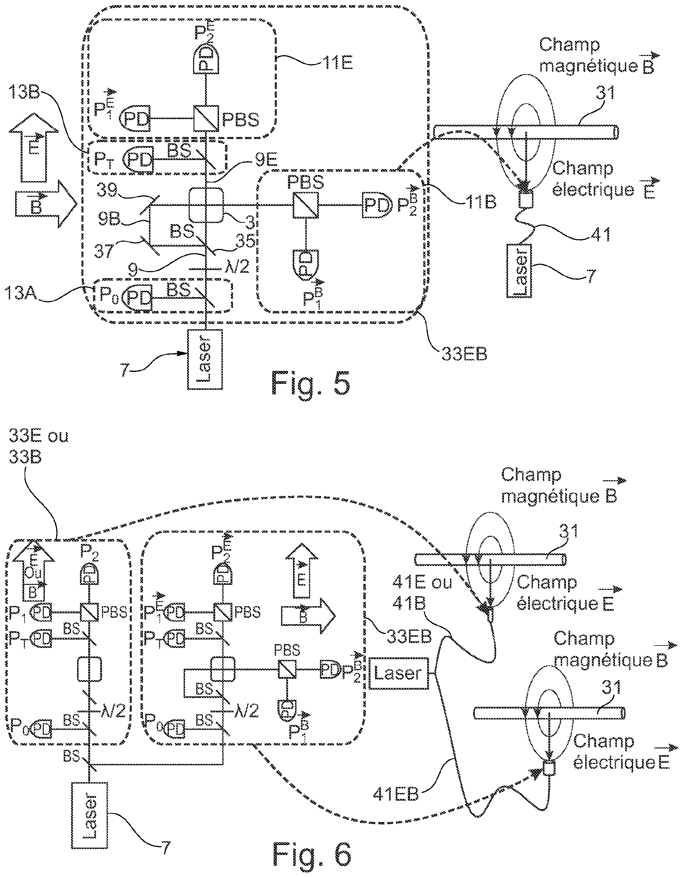

La figure 5 est une variante simplifiée et optimisée du mode de réalisation de la figure 4B combinant les têtes de mesure 33E et 33B en une seule tête de mesure 33EB. Dans ce cas, la tête de mesure 33EB comprend une lame séparatrice 35 du faisceau de lumière 9 en provenance de la source de lumière polarisée 7 en deux faisceaux partiels de lumière 9E et 9B, des réflecteurs pour définir deux branches de mesure perpendiculaires l'une à l'autre, la cellule de mesure 3 étant disposée dans la tête de mesure au croisement des deux faisceaux partiels 9E et 9B.

Dans ce montage, on a donc ajouté au montage présenté à la figure 3 avec un système de polarimétrie 11E la lame séparatrice 35 ainsi que deux réflecteurs 37 et 39 pour diriger le faisceau de lumière 9B dans la cellule de mesure 3 en croisant le faisceau de lumière 9B perpendiculairement avec celui du faisceau 9E. En sortie de la cellule de mesure 3, le faisceau 9B est dirigé vers un système de polarimétrie 11B.

Comme indiqué sur la figure 5, le faisceau de lumière polarisé 9 peut être acheminé vers la tête de mesure 33EB soit directement, soit par l'intermédiaire d'une fibre optique 41.

La figure 6 est un exemple de réalisation d'un dispositif de mesure 1 pour mesurer des champs électrique et/ou magnétique à proximité de plusieurs conducteurs électriques 31. Dans ce cas, les têtes de mesure 33, ici 33E ou B ainsi que 33EB peuvent être alimentés par le faisceau de lumière polarisé 9 d'un seul laser 7. Dans cet exemple, une tête de mesure 33E ou B est identique à celle de la figure 3 avec une orientation du faisceau de lumière colinéaire avec le champ électrique et une autre tête de mesure 33EB est identique à celle de la figure 5 pour mesurer à la fois les champs électrique et magnétique d'un conducteur électrique 31.

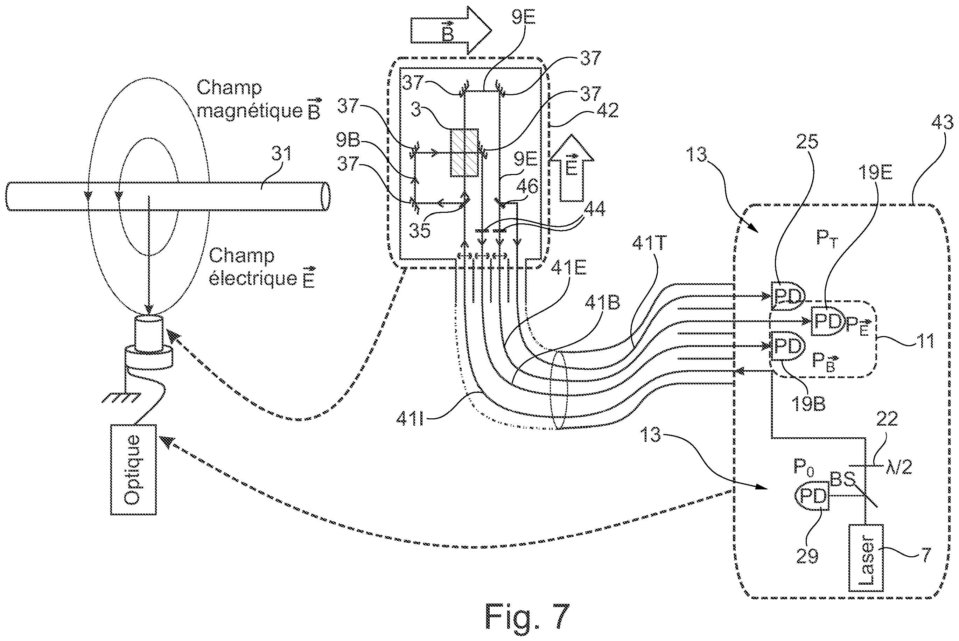

La figure 7 est un schéma simplifié d'un deuxième mode de réalisation dans lequel pour la partie tête de mesure 33EB, on sépare les fonctions optiques / placement de la cellule de mesure 3 et les fonctions de mesure avec les composants optroniques comprenant en particulier les photodétecteurs.

Ainsi, la tête de mesure 33 est divisée en une tête de sonde 42 et une embase de mesure 43.

La tête de sonde 42 comprend en son centre la cellule de mesure 3. Elle est en outre connectée à une fibre optique d'entrée 41I relié à la source de lumière 7 ainsi qu'une fibre optique de sortie 41E pour acheminer le faisceau partiel de lumière 9E ayant traversée la cellule de mesure 3 en étant colinéaire avec le champ électrique E vers une entrée correspondante de l'embase de mesure 43, une fibre optique de sortie 41B pour acheminer le faisceau partiel de lumière 9B ayant traversée la cellule de mesure 3 en étant colinéaire avec le champ magnétique B vers une entrée correspondante de l'embase de mesure 43 et une fibre optique de sortie 41T pour acheminer le faisceau partiel de lumière 9E ayant traversée la cellule de mesure 3 pour être acheminé vers à un photodétecteur 25 pour la mesure d'absorption

La fibre optique d'entrée 41I est une fibre à maintien de polarisation. Les fibres optique de sorties 41E, 41B, 41T sont des fibres à non-maintien de polarisation (mais l'utilisation de fibres optiques à maintien de polarisation est également possible, mais pas impératif). Dans la tête de sonde 42 sont donc seulement présents, outre la cellule de mesure 41, des réflecteurs 37,une lame séparatrice 35 disposée en amont de la cellule de mesure 3, deux polariseurs 44 par exemple sous forme de lame ou de cube, disposés en aval de la cellule de mesure 3 dans les faisceaux partiels de lumière 9E et 9B et une lame séparatrice 46 disposée en aval de la cellule de mesure 3 et en amont d'une des lames polariseurs 44, dans le présent exemple en particulier dans le faisceau partiel 9E. Pour des raisons mathématiques, l'axe des polariseurs 44 est mis à 45° par rapport à la polarisation d'entrée de la cellule 3.

Dans l'embase de mesure 43 sont installés la source de lumière 7, deux systèmes de polarimétrie 11E et 11B ainsi que le système de mesure d'absorption 13. Cette configuration permet de placer en particulier des photodétecteurs 19E, 19B, 25, 29 plus loin du conducteur électrique 31, par exemple de quelques mètres ou dizaines de mètres, voire plus. Ainsi les photodétecteurs 19E, 19B, 25, 29 peuvent être placés plus loin du conducteur électrique 31 afin de mieux s'affranchir des potentielles perturbations électromagnétiques pouvant être engendrées par les champs électrique et magnétique du conducteur électrique 31 sur les capteurs de mesure.

Selon une variante, l'embase de mesure 43 est installée et intégrée dans un boîtier métallique servant de cage de Faraday.

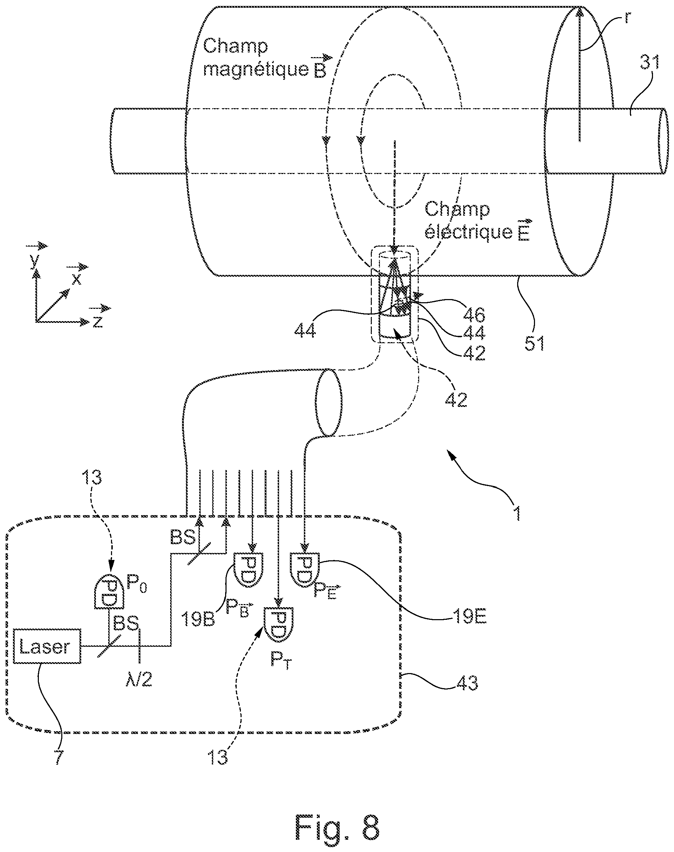

La figure 8 est un schéma simplifié et partiel d'un poste à enveloppe métallique 51 enfermant un conducteur électrique 31 moyenne ou haute tension et comprenant un dispositif de mesure 1 avec une embase de mesure 43 très similaire à celle de la figure 7 avec comme différence que la séparation en deux faisceau partiels 9E et 9B par la lame séparatrice 35 se fait dans l'embase de mesure 43 de sorte que quatre fibres optiques 41 sont reliées à la tête de sonde 42.

Pour les figures 7 et 8, les fibres optiques (par exemple 41I) en amont de la tête de sonde 42 sont donc des fibres à maintien de polarisation. La lame demi-onde $\lambda/2$ 22 utilisée en amont de la tête de sonde permet le réglage de la polarisation pour injecter le faisceau de la source de lumière 7 dans la/les fibres à maintien de polarisation selon un axe préférentiel de la fibre.

Les fibres optiques 41E, 41B, 41T utilisées pour les faisceaux en aval de la tête de sonde 42 sont par exemple des fibres à non-maintien de la polarisation (mais l'utilisation de fibres optiques à maintien de polarisation est également possible, mais pas impératif). La lame séparatrice 46 ajoutée au niveau de la tête de sonde 42 permet d'obtenir l'information d'absorption (donc de température) avec la fibre supplémentaire 41T.

Du côté de l'embase de mesure 43, les trois photodétecteurs 19E, 19B et 25 permettent l'analyse des signaux. Le photodétecteur 25 permet la mesure de l'absorption tandis que les photodétecteurs 19E et 19B permettent la mesure de l'angle de rotation et donc des champs à mesurer par les équations suivantes :

$$\theta_{\vec{E}} = \alpha_{att} \cdot \frac{1}{2} \cdot \sin^{-1}\left(\frac{2P_{\vec{E}}}{P_0} - 1\right) = \psi_{\overline{E}} \cdot n_{al} \cdot \ell \cdot E^2$$

$$\theta_{\vec{B}} = \alpha_{att} \cdot \frac{1}{2} \cdot \sin^{-1}\left(\frac{2P_{\vec{B}}}{P_0} - 1\right) = \psi_{\overline{B}} \cdot n_{al} \cdot \ell \cdot B$$

Avec

- $E$ = composante du champ électrique E colinéaire avec la direction de propagation du faisceau de lumière 9,
- $B$ = composante du champ magnétique B colinéaire avec la direction de propagation du faisceau de lumière 9,
- $\alpha_{att}$ le coefficient d'atténuation connue ou prédéterminé du faisceau de lumière
- $P_{\vec{E}}$ l'intensité de lumière mesurée par le photodecteur
- $P_{\vec{B}}$ l'intensité de lumière mesurée par le photodecteur
- $P_0$ l'intensité de lumière mesurée par le photodecteur

On comprend que le mode de réalisation des figures 7 et 8 comprend un système de polarimétrie simplifié avec pour chaque branche un polariseur 44 disposé en aval de la cellule de mesure 3 et un photodétecteur associé 19E, 19B. Dans ce cas, le faisceau en entrée de la cellule de mesure 3 est polarisé linéairement soit du fait de la source de lumière 7, soit en plaçant par exemple un polariseur en amont de la cellule de mesure 3.

Le système de mesure d'absorption 13 comprend par exemple un séparateur de faisceau 46 (par exemple une lame séparatrice ou un cube séparateur) qui est disposée en aval de la cellule de mesure 3 et en amont d'un polariseur 44 (par exemple sous forme de lame ou de cube) pour diriger une partie de faisceau vers un photodétecteur 25 du système de mesure d'absorption 13.

Bien entendu, cette version simplifiée peut être envisagé sans fibres optiques. Dans ce cas, l'utilisation d'un système de polarimétrie balancée peut aussi être envisagée.

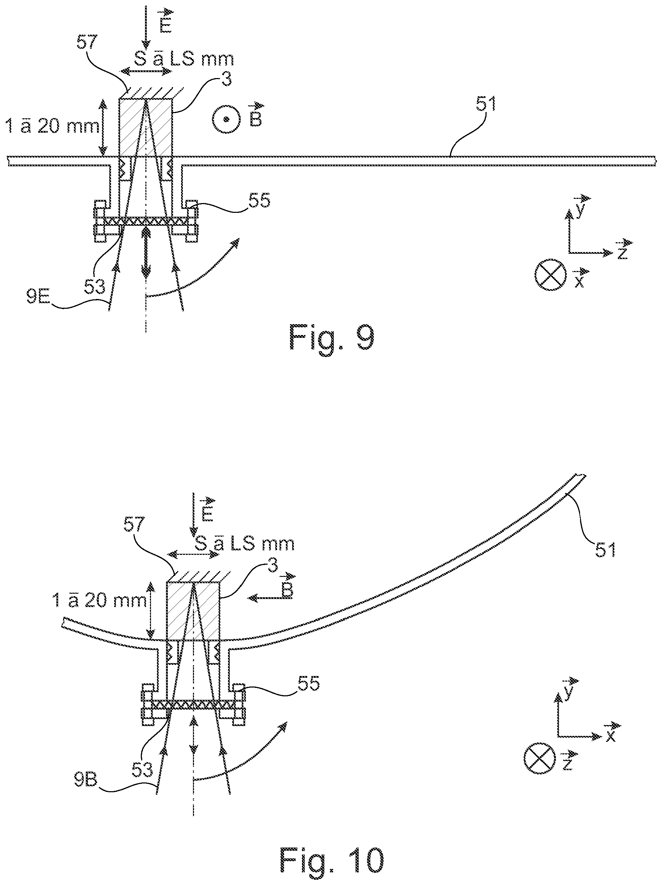

Les figures 9 et 10 sont des schémas simplifiés en coupe transversale d'un exemple de réalisation d'une tête de sonde 42 intégrée dans l'enveloppe métallique 51 selon deux plans de coupe perpendiculaires l'un à l'autre.

Comme on le voit sur les figures 9 et 10, la cellule de mesure 3 est disposée à l'intérieur de l'enveloppe métallique 51 et notamment fixée contre la partie interne de l'enveloppe métallique 51.

A cet effet, l'enveloppe métallique 51 comprend au niveau de la cellule de mesure 3 une fenêtre 53 fixée par une bride 55 pour laisser passer le faisceau de lumière 9E (figure 9) et 9B (figure 10).

Une paroi arrière 57 de la cellule de mesure 3 opposée à la fenêtre 53 est réfléchissante ou munie d'un miroir.

Ainsi, pour détecter le champ électrique E (figure 9), le faisceau de lumière 9E évolue dans un plan qui est perpendiculaire au champ magnétique B. Le faisceau de lumière 9E rentre sous un certain angle dans la cellule de mesure 3, est réfléchi par la paroi arrière 57 pour ensuite être envoyé vers l'embase de mesure 43.

Dans cette configuration, seule la composante colinéaire du faisceau de lumière 9E contribue à l'effet Stark. La taille de la cellule de mesure 3 peut être assez petite car le faisceau de lumière 9E traverse la cellule de mesure 3 deux fois (aller-retour).

Puis, pour détecter le champ magnétique B (figure 10), le faisceau de lumière 9B évolue sur un trajet où il est en partie colinéaire avec le champ magnétique B et avec le champ électrique E. Le faisceau de lumière 9B rentre sous un certain angle dans la cellule de mesure 3, est réfléchi par la paroi arrière 57 pour ensuite être envoyé vers l'embase de mesure 43.

Dans cette configuration, seules les composantes colinéaires des champs électrique E et magnétique B du faisceau de lumière 9B contribuent respectivement à l'effet Zeeman et à l'effet Stark. En déterminant d'abord le champ électrique E selon le montage de la figure 9, on peut déterminer le champ magnétique B par la mesure selon le montage de la figure 10 en retirant du résultat de mesure par calcul la contribution du champ électrique E qui est connu de la mesure selon le montage de la figure 9. La taille de la cellule de mesure 3 peut être assez petite car le faisceau de lumière 9B traverse la cellule de mesure 3 deux fois (aller-retour).

Par la suite, on va donner un exemple précis pour des mesures de courant et de tension qui est applicable à tous les modes de réalisation décrits.

On suppose que le gaz alcalin utilisé dans la cellule de mesure 3 est par exemple le rubidium pour l'effet Stark et l'effet Zeeman.

La relation entre le courant en Ampère (A) et l'angle de rotation de la polarisation $\theta_Z$ pour l'effet Zeeman est donnée par :

$$\theta_Z = A_{Zeeman} \cdot \frac{l_B \cdot w}{r} \cdot I \qquad\qquad (eq.\ 17)$$

avec

- r la distance entre le conducteur de courant 31 et la cellule de mesure 3 en mm,
- w le diamètre du faisceau de lumière 9 dans la cellule de mesure 3 en mm,
- $l_B$ longueur parcourue en mm de la partie du chemin du faisceau de lumière 9B qui est colinéaire avec le champ magnétique B.
- $4 \cdot 10^{-4} \mathrm{rad}.\frac{mm}{mm^2}/A < A_{Zeeman} < 1{,}2 \cdot 10^{-3}\ \mathrm{rad}.\frac{mm}{mm^2}/A$, cette fourchette est dépendante de la transition énergétique choisie de rubidium. Par inversion de cette équation, on remonte donc au courant dans le conducteur de courant 31.

La relation entre la tension U en kV et l'angle de rotation $\theta_S$ pour l'effet Stark est donnée par :

$$\theta_S = A_{Stark} \cdot \frac{l_E \cdot w}{\left(r \cdot \ln\left(\frac{r_0}{r}\right)\right)^2} \cdot U^2 \qquad\qquad (eq.\ 18)$$

avec

- $r_0$ le rayon du conducteur de courant 31 en mm,
- r la distance entre le conducteur de courant 31 et la cellule de mesure 3 en mm,
- $l_E$ longueur parcourue en mm de la partie du chemin du faisceau de lumière 9E qui est colinéaire avec le champ électrique E.

$$- 4 \cdot 10^{-3} \text{ rad.} \frac{\text{mm}^2}{\text{mm}^2} / \text{kV}^2 < A_{\text{Stark}} < 1{,}2 \cdot 10^{-2} \text{ rad.} \frac{\text{mm}^2}{\text{mm}^2} / \text{kV}^2$$

cette fourchette est dépendante de la transition énergétique choisie de rubidium. Par inversion de cette équation, on remonte donc à la tension.

Mesure de tension et de courant alternatif :
Lors de l'application d'une tension alternative $V(t) = V_O \cos(\omega t)$, on obtient un champ électrique défini par la relation suivante :

$$E(t) = \frac{V(t)}{r \ln\left(\frac{r_0}{r}\right)} \qquad \text{(eq. 19)}$$

Ainsi, on mesure un angle de rotation donné par la relation suivante :

$$\theta_{\overrightarrow{E}}(t) = \psi_{\overrightarrow{E}} \cdot n_{al} \cdot \ell \cdot E(t)^2 \qquad \text{(eq. 20)}$$

$$\theta_{\overrightarrow{E}}(t) = \frac{\psi_{\overrightarrow{E}} \cdot n_{al} \cdot \ell \cdot E_0^2}{2} [1 + \cos(2\omega t)] \qquad \text{(eq. 21)}$$

On obtient alors un signal composé de 2 composantes :

- une composante continue
- une composante alternative avec une fréquence 2 fois supérieure

Lors de l'application d'un courant alternatif $I(t) = I_O \cos(\omega t)$, on obtient un champ magnétique défini par la relation suivante :

$$B(t) = 4\pi\mu_0 \frac{I_0}{R} \qquad \text{(eq. 22)}$$

Ainsi, on mesure un angle de rotation donné par la relation suivante :

$$\theta_{\overrightarrow{B}}(t) = \psi_{\overrightarrow{B}} \cdot n_{al} \cdot \ell \cdot B(t) \qquad \text{(eq. 23)}$$

$$\theta_{\overrightarrow{B}}(t) = \psi_{\overrightarrow{B}} \cdot n_{al} \cdot \ell \cdot B_0 \cos(\omega t) \qquad \text{(eq. 24)}$$

On comprend donc que la présente invention se distingue par son faible encombrement, la partie active (gaz alcalin dans la cellule de mesure 3) pour le courant et la tension pouvant être inférieure en volume à 10 cm$^3$.
La partie active étant un gaz dans une cellule de mesure 3 étanche, la mesure physique est absolue et ne dérive pas dans le temps. Les seuls paramètres de dérive sont des paramètres contrôlables (température) ou qui peuvent être calibrées dans la partie déportée.
La seule pièce d'usure est potentiellement la source de lumière 7 qui peut être déportée du conducteur 31. La maintenance est donc facile et aisée.
La mesure optique présentée ci-dessus permet une mesure sensible et avec une forte bande passante.
Comme décrit ci-dessus, le dispositif de mesure est facile à implémenter. Les divers photodétecteurs n'ont pas besoin d'être en contact avec le conducteur de courant 31 pour la mesure du courant et de la tension. Ceci apporte aussi une isolation galvanique de la chaine de mesure du réseau électrique de puissance.

Enfin le dispositif de mesure 1 permet des mesures de courants et de tensions en courant continu comme en courant alternatif.

## Revendications

**1.** Dispositif de mesure (1) d'un champ magnétique, B, et/ou d'un champ électrique, E, comprenant :

- une cellule de mesure (3) renfermant un gaz sensible à l'effet Zeeman et/ou à l'effet Stark, en particulier un gaz alcalin, et destinée à être disposée dans un champ magnétique, B, ou électrique, E,
- une source de lumière (7) polarisée dont la longueur d'onde est accordée sur une raie d'absorption du gaz sensible à l'effet Zeeman et/ou à l'effet Stark et qui émet un faisceau de lumière (9) traversant ladite cellule de mesure (3),
- au moins un système de polarimétrie (11) configuré pour mesurer un premier paramètre correspondant à la rotation d'un angle de polarisation du fait de la traversée du faisceau (9) dans la cellule de mesure (3) renfermant un gaz sensible à l'effet Zeeman et/ou à l'effet Stark, le premier paramètre étant dépendant de la température dans la cellule de mesure (3),

**caractérisé en ce qu'il comprend en outre**

- un système de mesure d'absorption (13) configuré pour mesurer un deuxième paramètre correspondant au taux d'absorption du faisceau (9) par le gaz sensible à l'effet Zeeman et/ou l'effet Stark dans la cellule de mesure (3), ce deuxième paramètre étant dépendant de la température dans la cellule de mesure (3) et
- une unité de traitement (15) configurée pour combiner la mesure du premier paramètre correspondant à la rotation de l'angle de polarisation et le deuxième paramètre correspondant à un taux d'absorption mesuré par le système de mesure d'absorption pour en extraire un troisième et/ou quatrième paramètre indépendant de la température dans la cellule de mesure (3) correspondant respectivement à un champ électrique, E, et/ou magnétique, B, à mesurer.

**2.** Dispositif de mesure selon la revendication 1, dans lequel le gaz alcalin est du rubidium, du lithium, du sodium, du potassium, du césium ou du francium.

**3.** Dispositif de mesure selon l'une quelconque des revendications précédentes, dans lequel

- le système de polarimétrie (11) est configuré pour mesurer deux premiers paramètres correspondant respectivement à la rotation d'un angle de polarisation du fait de la traversée du faisceau (9) dans la cellule de mesure (3) renfermant un gaz sensible induit par l'effet Zeeman d'une part et par l'effet Stark d'autre part, le deux premiers paramètres étant dépendant de la température dans la cellule de mesure (3),
- l'unité de traitement (15) est configurée pour combiner la mesure des deux premiers paramètres correspondant à la rotation de l'angle de polarisation induit par l'effet Zeeman d'une part et par l'effet Stark d'autre part avec le deuxième paramètre correspondant au taux d'absorption mesuré par le système d'absorption pour en extraire un troisième et un quatrième paramètre indépendant de la température dans la cellule de mesure (3) correspondant respectivement à un champ électrique, E, et magnétique, B, à mesurer.

**4.** Dispositif de mesure selon l'une quelconque des revendications précédentes, dans lequel l'unité de traitement (15) est configurée pour extraire de la mesure d'absorption par le système d'absorption la température dans la cellule de mesure (3).

**5.** Dispositif de mesure selon l'une quelconque des revendications précédentes, dans lequel il comprend une tête de mesure (33) comprenant un séparateur de faisceau (35) du faisceau de lumière (9) en provenance de la source de lumière polarisée (7) en au moins deux faisceaux partiels (9E, 9B) de lumière et des réflecteurs (37, 39) pour définir deux branches de mesure perpendiculaires l'une à l'autre, la cellule de mesure (3) étant disposée dans la tête de mesure (33) au croisement des deux faisceaux partiels (9E, 9B).

**6.** Dispositif de mesure selon la revendication précédente, dans lequel la tête de mesure (33) est reliée à la source de lumière polarisée (7), le système de polarimétrie (11) et le système de mesure d'absorption (13) par des fibres

EP 3 729 107 B1

optiques (41).

7. Dispositif selon l'une quelconque des revendications précédentes, dans lequel le parcours du faisceau de lumière (9) traversant la cellule de mesure (3) présente au moins une composante colinéaire au champ magnétique, B, ou électrique , E, à mesurer ou est colinéaire au champ magnétique, B, ou électrique , E, à mesurer.

8. Dispositif selon l'une quelconque des revendications précédentes, dans lequel la cellule de mesure (3) est un cube ayant un premier côté de longueur comprise entre 0,1 mm et 20 mm et un deuxième côté de longueur comprise entre 0,1 mm et 25 mm ou un cylindre de hauteur comprise entre 0,1 mm et 20 mm et de diamètre compris entre 0,1 mm et 25 mm.

9. Dispositif selon l'une quelconque des revendications précédentes dans lequel le système de polarimétrie (11) est un système de polarimétrie balancée disposé en aval de la cellule de mesure (3) et comprenant un séparateur polariseur de faisceau (17) ainsi que deux photodétecteurs associés (19, 21).

10. Dispositif selon l'une quelconque des revendications 1 à 8, dans lequel le système de polarimétrie (11) comprend un polariseur (44) disposé en aval de la cellule de mesure (3) et un photodétecteur associé (19E, 19B), le faisceau en entrée de la cellule de mesure (3) étant polarisé linéairement.

11. Dispositif selon la revendication 7 et 10 prises ensembles, dans lequel un séparateur de faisceau (46) est disposée en aval de la cellule de mesure (3) et en amont d'un polariseur (44) pour diriger une partie de faisceau vers un photodétecteur (25) du système de mesure d'absorption (13).

12. Dispositif selon l'une quelconque des revendications précédentes dans lequel le système de mesure d'absorption (13) comprend une première et une deuxième lames séparatrices de faisceau (23, 27) disposées respectivement en amont et en aval de la cellule de mesure (3) ainsi que deux photodétecteurs (25, 29) associés à chacune des lames séparatrices de faisceau (23, 27) et configurés pour détecter l'intensité lumineuse du faisceau de lumière (9) en amont et en aval de la cellule de mesure (3).

13. Dispositif selon l'une quelconque des revendications précédentes dans lequel dans lequel la source de lumière (7) est un laser, notamment une diode laser.

14. Dispositif selon la revendication précédente dans lequel une unique source de lumière laser (7) est utilisée à la fois pour mesurer au moins un champ électrique, E, et au moins un champ magnétique, B.

15. Unité de mesure d'un courant et/ou d'une tension au niveau d'un conducteur électrique (31) de moyenne ou haute tension comprenant au moins un dispositif de mesure (1) selon l'une quelconque des revendications précédentes et en ce que l'unité de traitement (15) est en outre configurée pour déterminer en fonction de la distance entre le conducteur électrique (31) et la cellule de mesure (3) une tension par rapport à la terre et/ou un courant électrique circulant dans le conducteur (31).

16. Poste sous enveloppe métallique comprenant une enveloppe métallique (51) enfermant un conducteur électrique (31) moyenne ou haute tension, dans lequel il comprend un dispositif de mesure (1) selon l'une quelconque des revendications 1 à 14 dont la cellule de mesure (3) est disposée à l'intérieur du poste, notamment fixé contre la partie interne de l'enveloppe métallique (51).


**Patentansprüche**

1. Vorrichtung zum Messen (1) eines Magnetfeldes B, und/oder eines elektrischen Feldes E, umfassend:

   - eine Messzelle (3), die ein Gas enthält, das für den Zeeman-Effekt und/oder den Stark-Effekt empfindlich ist, insbesondere ein alkalisches Gas, und dazu bestimmt ist, in einem Magnetfeld, B, und/oder elektrischen Feld, E, angeordnet zu sein,
   - eine polarisierte Lichtquelle (7), deren Wellenlänge auf eine Absorptionslinie des Gases abgestimmt ist, das für den Zeeman-Effekt und/oder den Stark-Effekt empfindlich ist und die einen Lichtstrahl (9) emittiert, der die Messzelle (3) durchläuft,
   - zumindest ein polarimetrisches System (11), das konfiguriert ist, um einen ersten Parameter zu messen, welcher der Drehung eines Polarisationswinkels aufgrund des Durchlaufens des Strahls (9) durch die Messzelle (3) entspricht, die ein Gas enthält, das für den Zeeman-Effekt und/oder den Stark-Effekt empfindlich ist, wobei der erste Parameter von der Temperatur in der Messzelle (3) abhängt,

**dadurch gekennzeichnet, dass sie ferner Folgendes umfasst:**

- ein System zum Messen der Absorption (13), das konfiguriert ist, um einen zweiten Parameter zu messen, welcher der Absorptionsrate des Strahls (9) durch das Gas, das für den Zeeman-Effekt und/oder den Stark-Effekt empfindlich ist, in der Messzelle (3) entspricht, wobei dieser zweite Parameter von der Temperatur in der Messzelle (3) abhängt, und
- eine Verarbeitungseinheit (15), die konfiguriert ist, um die Messung des ersten Parameters, welcher der Drehung des Polarisationswinkels entspricht, und des zweiten Parameters zu kombinieren, welcher einer Absorptionsrate entspricht, die durch das System zum Messen der Absorption gemessen wird, um daraus einen dritten und/oder vierten Parameter unabhängig von der Temperatur in der Messzelle (3) entsprechend jeweils einem zu messenden elektrischen Feld, E, und/oder Magnetfeld, B, zu extrahieren.

2. Vorrichtung zum Messen nach Anspruch 1, wobei das alkalische Gas Rubidium, Lithium, Natrium, Kalium, Cäsium oder Francium ist.

3. Vorrichtung zum Messen nach einem der vorhergehenden Ansprüche, wobei

- das polarimetrische System (11) konfiguriert ist, um zwei erste Parameter zu messen, die jeweils der Drehung eines Polarisationswinkels aufgrund des Durchlaufens des Strahls (9) durch die Messzelle (3) entsprechen, die ein empfindliches Gas enthält, das durch den Zeeman-Effekt einerseits und durch den Stark-Effekt andererseits induziert wird, wobei die zwei ersten Parameter von der Temperatur in der Messzelle (3) abhängen,
- die Verarbeitungseinheit (15) konfiguriert ist, um die Messung der zwei ersten Parameter, die der Drehung des Polarisationswinkels entsprechen, der durch den Zeeman-Effekt einerseits und durch den Stark-Effekt andererseits induziert wird, mit dem zweiten Parameter zu kombinieren, welcher der Absorptionsrate entspricht, die durch das Absorptionssystem gemessen wird, um daraus einen dritten und einen vierten Parameter unabhängig von der Temperatur in der Messzelle (3) entsprechend jeweils einem zu messenden elektrischen Feld, E, und Magnetfeld, B, zu extrahieren.

4. Vorrichtung zum Messen nach einem der vorhergehenden Ansprüche, wobei die Verarbeitungseinheit (15) konfiguriert ist, um aus der Absorptionsmessung durch das Absorptionssystem die Temperatur in der Messzelle (3) zu extrahieren.

5. Vorrichtung zum Messen nach einem der vorhergehenden Ansprüche, wobei sie einen Messkopf (33) umfasst, der einen Strahlteiler (35) des Lichtstrahls (9) aus der polarisierten Lichtquelle (7) in zumindest zwei Teilstrahlen (9E, 9B) von Licht und Reflektoren (37, 39) umfasst, um zwei zueinander senkrechte Messzweige zu definieren, wobei die Messzelle (3) in dem Messkopf (33) an der Schnittstelle von zwei Teilstrahlen (9E, 9B) angeordnet ist.

6. Vorrichtung zum Messen nach dem vorhergehenden Anspruch, wobei der Messkopf (33) mit der polarisierten Lichtquelle (7), dem polarimetrischen System (11) und dem System zum Messen der Absorption (13) durch optische Fasern (41) verbunden ist.

7. Vorrichtung nach einem der vorhergehenden Ansprüche, wobei die Strecke des Lichtstrahls (9), der die Messzelle (3) durchläuft, zumindest eine Komponente aufweist, die kolinear zu dem zu messenden Magnetfeld, B, oder elektrischen Feld, E, ist, oder kolinear zu dem zu messenden Magnetfeld, B, oder elektrischen Feld, E, ist.

8. Vorrichtung nach einem der vorhergehenden Ansprüche, wobei die Messzelle (3) ein Würfel ist, der eine erste Längsseite, die zwischen 0,1 mm und 20 mm beträgt, und eine zweite Längsseite, die zwischen 0,1 mm und 25 mm beträgt, oder einen Zylinder mit einer Höhe, die zwischen 0,1 mm und 20 mm beträgt, und einem Durchmesser aufweist, der zwischen 0,1 mm und 25 mm beträgt.

9. Vorrichtung nach einem der vorhergehenden Ansprüche, wobei das polarimetrische System (11) ein ausgeglichenes polarimetrisches System ist, das nach der Messzelle (3) angeordnet ist und einen polarisierenden Strahlteiler (17) sowie zwei verbundene Fotodetektoren (19, 21) umfasst.

**10.** Vorrichtung nach einem der vorhergehenden Ansprüche 1 bis 8, wobei das polarimetrische System (11) einen Polarisator (44), der nach der Messzelle (3) angeordnet ist, und einen verbundenen Fotodetektor (19E, 19B) umfasst, wobei der Eingangsstrahl der Messzelle (3) linear polarisiert ist.

**11.** Vorrichtung nach Anspruch 7 und 10 zusammengenommen, wobei ein Strahlteiler (46) nach der Messzelle (3) und vor dem Polarisator (44) angeordnet ist, um einen Teilstrahl in Richtung eines Fotodetektors (25) des Systems zum Messen der Absorption (13) zu lenken.

**12.** Vorrichtung nach einem der vorhergehenden Ansprüche, wobei das System zum Messen der Absorption (13) ein erstes und ein zweites Blatt zum Trennen des Strahls (23, 27), die jeweils vor und nach der Messzelle (3) angeordnet sind, sowie zwei Fotodetektoren (25, 29) umfasst, die mit jedem der Blätter zum Trennen des Strahls (23, 27) verbunden und konfiguriert sind, um die Lichtintensität des Lichtstrahls (9) vor und nach der Messzelle (3) zu erfassen.

**13.** Vorrichtung nach einem der vorhergehenden Ansprüche, wobei die Lichtquelle (7) ein Laser, insbesondere ein Diodenlaser ist.

**14.** Vorrichtung nach dem vorhergehenden Anspruch, wobei jeweils eine einzelne Laserlichtquelle (7) verwendet wird, um zumindest ein elektrisches Feld, E, und zumindest ein Magnetfeld, B, zu messen.

**15.** Einheit zum Messen eines Stroms und/oder einer Spannung an einem elektrischen Leiter (31) mit mittlerer oder hoher Spannung, umfassend zumindest eine Vorrichtung zum Messen (1) nach einem der vorhergehenden Ansprüche und, dass die Verarbeitungseinheit (15) ferner konfiguriert ist, um abhängig von dem Abstand zwischen dem elektrischen Leiter (31) und der Messzelle (3) eine Spannung in Bezug auf die Masse und/oder einen elektrischen Strom zu bestimmen, der in dem Leiter (31) zirkuliert.

**16.** Posten mit metallischer Umhüllung, umfassend eine metallische Umhüllung (51), die einen elektrischen Leiter (31) mittlerer oder hoher Spannung umschließt, wobei er eine Vorrichtung zum Messen (1) nach einem der vorhergehenden Ansprüche 1 bis 14 umfasst, deren Messzelle (3) im Inneren des Postens angeordnet ist, insbesondere an dem inneren Teil der metallischen Umhüllung (51) befestigt.

**Claims**

**1.** A measurement device (1) for measuring a magnetic field (B) and/or an electric field (E), comprising:

- a measurement cell (3) containing a gas sensitive to the Zeeman effect and/or to the Stark effect, in particular an alkaline gas, and intended to be arranged in a magnetic field (B) and/or electric field (E),
- a polarized light source (7) whose wavelength is tuned to an absorption line of the gas sensitive to the Zeeman effect and/or to the Stark effect and that emits a light beam (9) passing through said measurement cell (3),
- at least one polarimetry system (11) configured so as to measure a first parameter corresponding to the rotation of a polarization angle due to the beam (9) passing into the measurement cell (3) containing a gas sensitive to the Zeeman effect and/or to the Stark effect, the first parameter being dependent on the temperature in the measurement cell (3),

**characterized in that** it further comprises:

- an absorption measurement system (13) configured so as to measure a second parameter corresponding to the absorption rate of the beam (9) by the gas sensitive to the Zeeman effect and/or the Stark effect in the measurement cell (3), this second parameter being dependent on the temperature in the measurement cell (3), and
- a processing unit (15) configured so as to combine the measurement of the first parameter corresponding to the rotation of the polarization angle and the second parameter corresponding to an absorption rate measured by the absorption measurement system in order to extract therefrom a third and/or fourth parameter independent of the temperature in the measurement cell (3) corresponding to an electric field E and/or magnetic field B to be measured, respectively.

**2.** The measurement device as claimed in claim 1, wherein the alkaline gas is rubidium, lithium, sodium, potassium, caesium or francium.

3. The measurement device as claimed in either one of the preceding claims, wherein

- the polarimetry system (11) is configured so as to measure two first parameters corresponding respectively to the rotation of a polarization angle due to the beam (9) passing into the measurement cell (3) containing a sensitive gas induced by the Zeeman effect, on the one hand, and by the Stark effect, on the other hand, the two first parameters being dependent on the temperature in the measurement cell (3),
- the processing unit (15) is configured so as to combine the measurement of the two first parameters corresponding to the rotation of the polarization angle induced by the Zeeman effect, on the one hand, and by the Stark effect, on the other hand, with the second parameter corresponding to the absorption rate measured by the absorption system in order to extract therefrom a third and a fourth parameter independent of the temperature in the measurement cell (3) corresponding to an electric field E and magnetic field B to be measured, respectively.

4. The measurement device as claimed in any one of the preceding claims, wherein the processing unit (15) is configured so as to extract the temperature in the measurement cell (3) from the absorption measurement by the absorption system.

5. The measurement device as claimed in any one of the preceding claims, wherein it comprises a measurement head (33) comprising a beam splitter (35) for splitting the light beam (9) from the polarized light source (7) into at least two partial light beams (9E, 9B) and reflectors (37, 39) for defining two measurement branches perpendicular to one another, the measurement cell (3) being arranged in the measurement head (33) at the intersection of the two partial beams (9E, 9B).

6. The measurement device as claimed in the preceding claim, wherein the measurement head (33) is connected to the polarized light source (7), the polarimetry system (11) and the absorption measurement system (13) by optical fibers (41).

7. The device as claimed in any one of the preceding claims, wherein the path of the light beam (9) passing through the measurement cell (3) has at least one component collinear with the magnetic field B or electric field E to be measured or is collinear with the magnetic field B or electric field E to be measured.

8. The device as claimed in any one of the preceding claims, wherein the measurement cell (3) is a cube having a first side of a length between 0.1 mm and 20 mm and a second side of a length between 0.1 mm and 25 mm or a cylinder of a height between 0.1 mm and 20 mm and a diameter between 0.1 mm and 25 mm.

9. The device as claimed in any one of the preceding claims, wherein the polarimetry system (11) is a balanced polarimetry system arranged downstream of the measurement cell (3) and comprising a polarizing beam splitter (17) as well as two associated photodetectors (19, 21).

10. The device as claimed in any one of claims 1 to 8, wherein the polarimetry system (11) comprises a polarizer (44) arranged downstream of the measurement cell (3) and an associated photodetector (19E, 19B), the beam at the input of the measurement cell (3) being linearly polarized.

11. The device as claimed in claim 7 and 10 taken together, wherein a beam splitter (46) is arranged downstream of the measurement cell (3) and upstream of a polarizer (44) in order to direct part of the beam to a photodetector (25) of the absorption measurement system (13).

12. The device as claimed in any one of the preceding claims, wherein the absorption measurement system (13) comprises a first and a second beam splitter plate (23, 27) arranged respectively upstream and downstream of the measurement cell (3), and two photodetectors (25, 29) associated with each of the beam splitter plates (23, 27) and configured so as to detect the luminous intensity of the light beam (9) upstream and downstream of the measurement cell (3).

13. The device as claimed in any one of the preceding claims, wherein the light source (7) is a laser, notably a laser diode.

14. The device as claimed in the preceding claim, wherein a single laser light source (7) is used to measure both at least one electric field E and at least one magnetic field B.

15. A unit for measuring a current and/or a voltage in a medium-voltage or high-voltage electrical conductor (31), comprising at least one measurement device (1) as claimed in any one of the preceding claims, and in that the processing unit (15) is furthermore configured so as to determine a voltage relative to ground and/or an electric current flowing in the conductor (31) on the basis of the distance between the electrical conductor (31) and the measurement cell (3).

16. Substation included in a metal casing; comprising a metal casing (51) enclosing a medium-voltage or high-voltage electrical conductor (31), wherein it comprises a measurement device (1) as claimed in any one of claims 1 to 14, the measurement cell (3) of which is arranged inside the substation, notably fixed to the inner part of the metal casing (51).

Fig. 1

Fig. 2

Fig. 3

Fig. 4A

Fig. 4B

Fig. 5

Fig. 6

Fig. 7

Fig. 8

Fig. 9

Fig. 10

## RÉFÉRENCES CITÉES DANS LA DESCRIPTION

**Documents brevets cités dans la description**

- EP 0453693 A
- EP 0108012 A
- CN 206057424
- US 20120113423 A1